(19)

Europäisches
Patentamt
European
Patent Office
Office européen
des brevets

(11)  **EP 4 632 420 A1**

(12)  **EUROPEAN PATENT APPLICATION**

(43) Date of publication:
**15.10.2025  Bulletin 2025/42**

(21) Application number: **24315160.2**

(22) Date of filing: **12.04.2024**

(51) International Patent Classification (IPC):
*G01R 33/60* (2006.01)

(52) Cooperative Patent Classification (CPC):
**G01R 33/60**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Bruker France S.A.S.
67166 Wissembourg Cédex (FR)**

(72) Inventors:
• **SCHAEFFER, Jacky
67490 Printzheim (FR)**

• **SCHMITTER, Fabian
8603 Schwerzenbach (CH)**

(74) Representative: **Kohler Schmid Möbus
Patentanwälte
Partnerschaftsgesellschaft mbB
Gropiusplatz 10
70563 Stuttgart (DE)**

Remarks:
Amended claims in accordance with Rule 137(2)
EPC.

(54)  **EPR SPECTROMETER WITH A MICROWAVE SOURCE COMPRISING A FIXED FREQUENCY MICROWAVE OSCILLATOR AND A TUNABLE HF GENERATOR AND CORRESPONDING METHOD**

(57)     An electron paramagnetic resonance (=EPR) spectrometer (1), comprising
- a sample resonator (2), comprising a sample area (3) for a measurement sample (4) to be held in the sample resonator (2);
- a tunable microwave source (7), for generating a tunable microwave signal to be applied to the sample resonator (2),
- a magnet system (5), for generating a variable magnetic field to be applied at least to the sample area (3) in the sample resonator (2), and
- and a microwave detector (9) connected to the sample resonator (2) for detecting microwave radiation,
is characterized in that the tunable microwave source (7) comprises
- a fixed frequency microwave oscillator (20), for generating a fixed frequency microwave signal,
- a tunable frequency generator (27), for generating a tunable high frequency (=HF) signal, wherein the tunable HF signal is of lower frequency as compared to the fixed frequency microwave signal, and
- a mixer (32), for mixing the fixed frequency microwave signal and the tunable HF signal, thus generating a tunable microwave signal. The invention provides an EPR spectrometer with high spectral resolution, which is simple and inexpensive in production and operation.

Fig. 2

**Description**

The invention relates to an electron paramagnetic resonance (=EPR) spectrometer, comprising

- a sample resonator, comprising a sample area for a measurement sample to be held in the sample resonator;
- a tunable microwave source, for generating a tunable microwave signal to be applied to the sample resonator,
- a magnet system, for generating a variable magnetic field to be applied at least to the sample area in the sample resonator, and
- and a microwave detector connected to the sample resonator for detecting microwave radiation.

Such a method is known from US 5,309,118.
Electron paramagnetic resonance (=EPR), also referred to as electron spin resonance, is a powerful tool in instrumental analytics to investigate the chemical composition of samples having a permanent magnetic moment, which results from unpaired electrons in the sample. The sample is exposed to an external magnetic field, and a resonant microwave absorption is measured.
In practice, the sample is placed in the sample area of a sample resonator. A microwave source generates microwave radiation which is applied to the sample resonator (also called applied microwave signal). The applied microwave signal has a frequency corresponding to the resonant frequency of the microwave resonator containing the sample. It should be noted that the presence of the sample influences the resonance frequency of the microwave resonator, so different samples having a different chemical composition may lead to different resonant frequencies of the microwave resonator. Further note that external factors like the temperature may influence the resonance frequency of the sample resonator. Therefore, the microwave source is tunable in order to adapt to the particular measurement situation. Typical EPR spectrometers operate in frequency ranges of 9-10 GHz (X-band) or of 33-35 GHz (Q-band).
Further, the sample is exposed to a magnetic field. This leads to a splitting of energy levels of the unpaired electrons in the sample, depending on the strength of the magnetic field and the chemical characteristics of the sample. If the energy of the applied microwave signal equals the splitting of energy levels, microwave energy is absorbed by the sample, what is registered at a microwave detector. In continuous wave (=CW) EPR, in order to obtain an EPR spectrum of the sample, a magnet system generates a magnetic field which is slightly amplitude-modulated, e.g. at 100 kHz, and the microwave frequency is kept constant.
In order to obtain high resolution EPR spectra of samples, the tunable microwave source should have a high spectral purity, resulting in low phase noise.
US 5,309,118 describes a microwave source for use in EPR spectroscopy, wherein a resonant cavity source incorporates a resonant active element directly into the cavity. GUNN effect diodes are used as the active element, which are difficult to obtain. Further, the geometry of the cavity is changed by a mobile closure plate in order to modify the microwave frequency. Water cooling is applied during operation.
While this type of microwave source may produce microwave radiation with excellent spectral purity, production and operation cause relatively high costs and large efforts.
Microwave radiation can be produced by voltage controlled oscillators (=VCO). However, VCOs operating in the X-band or Q-band generate significant phase noise. Therefore, VCOs are only used in entry-level EPR spectrometers.
Wei et al., Photonics Research Vol. 6, No. 1, January 2018, pages 12-17, propose a frequency synthesizer for radar systems. It comprises a mode locked laser (=MLL) stabilized to an all-fiber reference, wherein a 10 GHz microwave signal is extracted. A direct digital synthesizer generates signals up to 1 GHz. The DDS output is mixed with the stabilized 10 GHz signal to obtain a 9-11 GHz tunable microwave signal.
CN 209881736 describes a Ku-waveband low phase noise microwave source, comprising a local oscillator circuit, a DDS circuit, a mixer and a frequency multiplication filter circuit using harmonic filters.

<u>Object of the invention</u>

It is the object of the present invention to provide an EPR spectrometer with high spectral resolution, which is simple and inexpensive in production and operation.

<u>Short description of the invention</u>

This object is achieved, in accordance with the invention, by an EPR spectrometer as mentioned in the beginning, characterized in that the tunable microwave source comprises

- a fixed frequency microwave oscillator, for generating a fixed frequency microwave signal,
- a tunable frequency generator, for generating a tunable high frequency (=HF) signal, wherein the tunable HF signal is of lower frequency as compared to the fixed frequency microwave signal, and

- a mixer, for mixing the fixed frequency microwave signal and the tunable HF signal, thus generating a tunable microwave signal.

The invention suggests an EPR spectrometer, wherein the microwave signal to be applied to the sample resonator is generated using a fixed frequency microwave oscillator, a tunable frequency generator, and a mixer.

The fixed frequency microwave oscillator generates a fixed frequency microwave signal. This can be done in a relatively simple way with a high spectral purity or low phase noise at a fixed microwave frequency chosen close to or within the microwave band (e.g. X-band or Q-band) desired for the EPR measurement.

Further, a tunable frequency generator generates a tunable high frequency (=HF) signal. The HF signal has a lower frequency as compared to the fixed frequency microwave signal, typically by a factor or 3 or more, often by a factor 5 or more or even by a factor 10 or more. This, too, can be done in a relatively simple way with a high spectral purity or low phase noise. Typically, the tunable HF signal is generated in a range 3 GHz or less, and often 1 GHz or less.

By means of a mixer, the fixed frequency microwave signal and the tunable HF signal are mixed, resulting in a tunable microwave signal having a first mode with a microwave frequency lower than the frequency of the fixed frequency microwave signal, and a second mode with a microwave frequency higher than the frequency of the fixed frequency microwave signal. By adjusting the frequency of the tunable HF signal, also the microwave frequencies of the two modes of the tunable microwave frequency can be adjusted. One of the modes may be chosen for being applied to the sample resonator of the EPR spectrometer; the other mode is typically filtered out. Preferably, the first mode (lower frequency mode) is chosen for being applied to the EPR spectrometer.

By mixing a fixed frequency microwave signal of high spectral purity (and low phase noise) and a tunable HF signal of high spectral purity (and low phase noise), a tunable microwave signal of high spectral purity (and low phase noise) can be obtained. This is relatively simple to do, in particular as compared to generating a tunable microwave signal of high spectral purity directly as in the state of the art in know EPR spectrometers.

Typically, the fixed frequency microwave signal is chosen with a frequency at (or even beyond) one of the two ends of the desired bandwidth interval for the EPR measurements. This avoids generation of two frequencies with the desired bandwidth interval, what would complicate obtaining a high spectral purity.

Preferred variants of the invention

A preferred embodiment of the inventive EPR spectrometer provides that the fixed frequency microwave oscillator is suitable for providing the fixed frequency microwave signal with a phase noise of -135dBc or less at an offset of 100 kHz, and that the tunable frequency generator is suitable for providing the tunable HF signal with a phase noise of -135 dBc or less at an offset of 100 kHz. Using such low noise input signals for the mixer, also a tunable microwave signal with a phase noise of -135dBc or less at an offset of 100 kHz can be provided by the mixer in a simple way. Preferably, the EPR spectrometer is adapted for providing a fixed frequency microwave signal and a tunable HF signal as well as a resulting tunable microwave signal each with a phase noise of noise of - 140dBc or less at an offset of 100 kHz.

In a highly preferred variant of the inventive EPR spectrometer, the EPR spectrometer further comprises an automatic frequency control (=AFC) system, wherein the AFC system is adapted to

- receive a measured microwave signal provided by the microwave detector;
- derive an AFC adjustment signal from the measured microwave signal, with the AFC adjustment signal indicating a deviation of a current frequency of the measured microwave signal from a current resonance frequency of the sample resonator; and
- feed the AFC adjustment signal into the tunable frequency generator, for continuously controlling a current frequency of the tunable HF signal, such that the current frequency of the tunable microwave signal is continuously adjusted to the current resonance frequency of the sample resonator. By means of the AFC system, the sample resonator can reliably and continuously be operated at its resonance frequency, so the EPR measurements are performed correctly (without distortions/artefacts due to a detuning of the applied microwave frequency with respect to the resonance frequency). In an example for the AFC system, the AFC system may be further adapted to effect a modulation of the tunable HF signal with a modulation frequency, resulting in a modulation of the tunable microwave signal with the modulation frequency, and to derive the AFC adjustment signal from the measured microwave signal using said modulation; however note that also other variants for obtaining the AFC adjustment signal may be applied.

In a preferred embodiment, the fixed frequency microwave oscillator includes a resonant cavity, in particular a resonant cylindrical cavity. This is a simple and inexpensive way to provide a fixed frequency microwave oscillator with high spectral purity or low phase noise. The resonant cavity should be made from a material of high electric conductivity. In an example, the resonant cavity is made of aluminium. Further, the cavity surface may carry an (inner) coating of high electrical conductivity. In an example, the cavity surface carries a silver coating. The resonant cavity has a fixed geometry. Further note that in an alternative embodiment, the fixed frequency microwave oscillator may include a dielectric resonator or an optical fiber.

Advantageously, the fixed frequency microwave oscillator includes a selective return chain element, a low noise amplifier, a phase shifter and a coupler connected circularly in series. In this way, a very stable and pure fixed frequency microwave signal may be generated. The selective return chain element may be a resonant cavity or a dielectric resonator or an optical fiber, for example. The phase shifter is typically a 180° phase shifter,

In a preferred embodiment, the tunable frequency generator includes a direct digital synthesizer (=DDS). This has proven very suitable for the invention in practice, and allows for excellent spectral purity or low phase noise of the tunable HF signal. The DDS may comprise a phase/frequency control register to which a control signal is applied, a numerically controlled oscillator (=NCO), a digital to analogue (=D/A) converter, and a reconstruction filter; a reference signal (also called reference clock) is applied to the phase/frequency control register, the NCO and the D/A converter.

In a preferred further development of the above embodiment, the tunable frequency generator further includes

- a coupler for obtaining a part of the fixed frequency microwave signal, and
- a frequency divider, for generating a frequency-divided signal from said part of the fixed frequency microwave signal, and providing the frequency divided signal as a reference signal into the DDS. In this way, the DDS can be operated in a simple and accurate way. The frequency divider may in particular apply a divisor of 4. The frequency-divided signal is used as reference signal (reference clock) by the DDS.

In a preferred embodiment, the tunable frequency generator includes a voltage controlled oscillator (=VCO). In this way, a tunable HF signal can also be provided in a simple and inexpensive way.

Advantageously, the mixer only preserves a difference of the fixed frequency microwave signal and the tunable HF signal. This way the tunable microwave signal can be efficiently obtained at high spectral purity or low phase noise.

Advantageously, the mixer is a single sideband mixer. This is simple and inexpensive to implement.

Alternatively, the mixer is a single balanced mixer, or a double balanced mixer, or a triple balanced mixer. These mixer types can suppress AM noise included in the tunable HF signal, and have an improved linearity.

In a preferred embodiment, the EPR spectrometer further includes a low noise main amplifier, for amplifying the tunable microwave signal provided by the mixer before applying it to the sample resonator. In this way, the amplitude of the tunable microwave signal can be adapted to the needs of the EPR measurement, and the signal to noise ratio of the EPR measurement can be improved.

Preferred is an embodiment providing that

a) the fixed frequency microwave oscillator is adapted to generate a fixed frequency microwave signal of a frequency Ffix with

8.5 GHz ≤ Ffix ≤ 10.5 GHz,
and the tunable frequency generator is adapted to generate a tunable HF signal of up to a frequency Fmax with 0.5 GHz ≤ Fmax ≤ 1.5 GHz,
in particular wherein Ffix=10 GHz and Fmax=1 GHz,
or that

b) the fixed frequency microwave oscillator is adapted to generate a fixed frequency microwave signal of a frequency Ffix with

32.0 GHz ≤ Ffix ≤ 36.0 GHz,
and the tunable frequency generator is adapted to generate a tunable HF signal of up to a frequency Fmax with 1.0 GHz ≤ Fmax ≤ 3.0 GHz,
in particular wherein Ffix=35 GHz and Fmax=2 GHz. This has shown to allow for EPR measurements on samples in the X-band or Q-band with excellent resolution in a simple and inexpensive way.

Also within the scope of the present invention is a method for measuring an EPR spectrum of a measurement sample,

wherein the measurement sample is positioned in a sample area of a sample resonator,
wherein a tunable microwave signal is applied to the sample resonator,
wherein a variable magnetic field is applied at least to the measurement sample in the sample area in the sample resonator,

and wherein a microwave detector connected to the sample resonator detects microwave radiation, characterized in

that the tunable microwave signal is generated by mixing a fixed frequency microwave signal obtained from a fixed frequency microwave oscillator with a tunable high frequency (=HF) signal obtained from tunable frequency generator, wherein the tunable HF signal has a lower frequency as compared to the fixed frequency microwave signal, in particular wherein the method is performed with an inventive EPR spectrometer as described above. With the inventive method, a tunable microwave signal of high spectral purity or low phase noise may become available, and in turn EPR measurements of high spectral resolution become available in a simple and inexpensive way.

A preferred variant of the above method provides that the fixed frequency microwave signal has a phase noise of -135 dBc or less at an offset of 100 kHz, and that the tunable HF signal has a phase noise of -135 dBc or less at an offset of 100 kHz. Then a tunable microwave signal having a phase noise of - 135 dBc or less at an offset of 100 kHz can be made available in a simple way.

In a particularly advantageous variant, the method applies an automatic frequency control (=AFC) including

- receiving a measured microwave signal provided by the microwave detector;
- deriving an AFC adjustment signal from the measured microwave signal, with the AFC adjustment signal indicating a deviation of a current frequency of the measured microwave signal from a current resonance frequency of the sample resonator;
- feeding the AFC adjustment signal into the tunable frequency generator, thus continuously controlling a current frequency of the tunable HF signal, such that the current frequency of the tunable microwave signal is continuously adjusted to the current resonance frequency of the sample resonator. By means of the AFC system, the sample resonator can reliably and continuously be operated at its resonance frequency, so the EPR measurements are performed correctly (without distortions/artefacts).

In a preferred further development of this variant, the automatic frequency control (=AFC) further includes

- effecting a modulation of the tunable HF signal with a modulation frequency, resulting in a modulation of the tunable microwave signal with the modulation frequency,
- deriving the AFC adjustment signal from the measured microwave signal using said modulation. This is a simple way to establish AFC. However note that other ways to obtain an AFC adjustment signal may be applied alternatively.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

Drawing

The invention is shown in the drawing.

Fig. 1    shows schematically an exemplary embodiment of an EPR spectrometer according to the invention;

Fig. 2    shows schematically the tunable microwave source of the EPR spectrometer of Fig. 1, comprising a DDS;

Fig. 3    shows schematically the major components of an AFC system of the EPR spectrometer of Fig. 1;

Fig. 4    illustrates the generation of an AFC adjustment signal with the AFC system of Fig. 3, wherein the frequency of the tunable microwave signal equals the resonance frequency of the sample resonator;

Fig. 5    illustrates the generation of an AFC adjustment signal in the AFC system of Fig. 3, wherein the frequency of the tunable microwave signal is larger than the resonance frequency of the sample resonator;

Fig. 6    illustrates the generation of an AFC adjustment signal in the AFC system of Fig. 3, wherein the frequency of the tunable microwave signal is smaller than the resonance frequency of the sample resonator;

Fig. 7    shows schematically an alternative tunable microwave source for the EPR spectrometer of Fig. 1 in accordance with the invention, in a variant comprising a VCO.

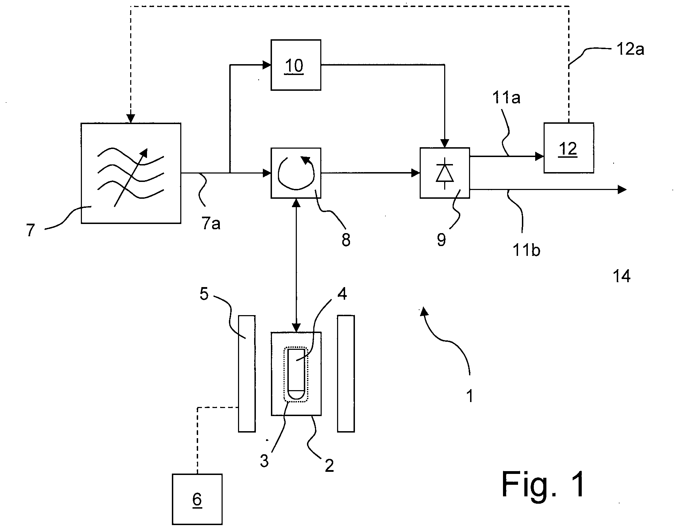

**Fig. 1** shows schematically an exemplary embodiment of an inventive EPR spectrometer 1.

The EPR spectrometer comprises a sample resonator 2, containing a sample area 3 for a measurement sample 4. In the embodiment shown, the measurement sample 4 comprises a sample tube that is held in the sample area 3, and the sample tube contains some measurement substance having unpaired electrons.

A magnet system 5 generates a magnetic field that is applied in the sample area 3. The applied magnetic field is slightly modulated by the magnet system 5, which is controlled via an electronic control unit 6; the electronic control unit 6 typically comprises a lock in signal generator (not shown in detail). The modulated magnetic field has a dominating constant part and an additional varying part; the varying part here varies sinusoidally at a frequency of e.g. 100 kHz, and the amplitude of the varying part is significantly smaller as compared to the amplitude of the constant part. For example, the amplitude of the varying part may be 1 % or smaller as compared to the amplitude of the constant part.

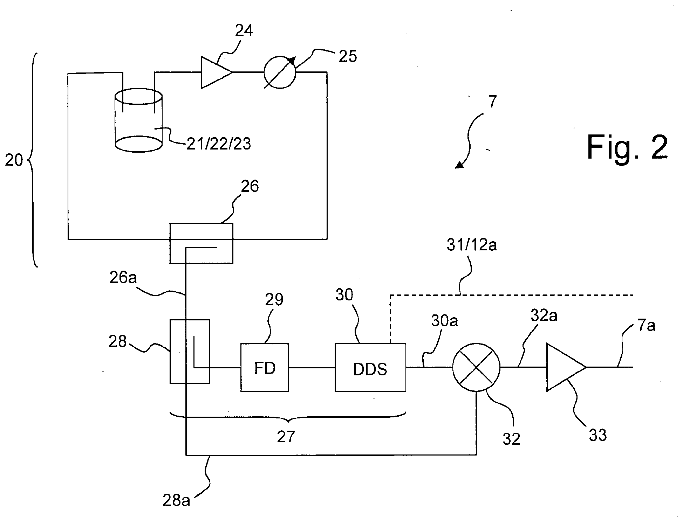

The EPR spectrometer 1 further comprises a tunable microwave source 7, details of which are further described in Fig. 2. A tunable microwave signal generated by the tunable microwave source 7 at its output 7a is fed to a circulator 8, which forwards the tunable microwave signal to the sample resonator 2, and also receives returning microwave radiation from the sample resonator 2, which is forwarded to a microwave detector 9. Some of the tunable microwave signal is also lead through a reference arm unit 10, and a reference arm signal is also fed into the microwave detector 9.

The sample resonator 2 is critically coupled. As long as no energy transition of the sample material in the measurement sample 4 is in resonance, the sample resonator 2 absorbs an incoming microwave signal completely. If an energy transition gets into resonance, the absorption in the sample resonator 2 becomes incomplete, what can be detected at the microwave detector 9 as a measured microwave signal.

A first part of the measured microwave signal containing sample information is provided at a sample detection output 11b of the microwave detector 2. The sample detection output 11b is typically connected to a lock in amplifier (not shown).

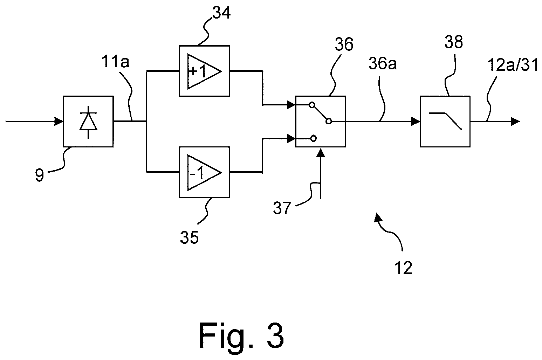

Further, a second part of the measured microwave signal is provided at an AFC processing output 11a of the microwave detector 9, and fed to an AFC system 12, the details of which are explained in Fig. 3. The AFC system 12 generates an AFC adjustment signal at an AFC system output 12a, which is fed to the tunable microwave source 7. By means of the AFC adjustment signal, the current frequency of the tunable microwave signal generated by the tunable microwave source 7 can be controlled and kept at the current resonance frequency of the sample resonator 2.

**Fig. 2** illustrates the tunable microwave source 7 of Fig. 1 in more detail. It should be noted that the design of the tunable microwave source 7 described in Fig. 2 is an exemplary one, and other designs may be chosen without leaving the scope of the present invention.

The tunable microwave source 7 comprises a fixed frequency microwave oscillator 20. The fixed frequency microwave oscillator 20 includes a selective return chain element 21, which is here a resonant cavity 22. The resonant cavity 22 is here a resonant cylindrical cavity 23, operating in resonance mode TM010 (transverse magnetic). Note that the resonance frequency of the resonant cylindrical cavity 23 depends on its diameter, but not on its length. The resonant cavity 22 is machined from aluminium and carries an inside silver coating in the illustrated embodiment (not shown in detail). In general, a quality factor QF of the resonant cavity 22 should be ≥2000, preferably ≥4000. For coupling, the two ribbon tracks on a printed circuit board can be used in the resonator cavity 22. Further, the fixed frequency microwave oscillator 20 further comprises a low noise amplifier 24, a phase shifter 25, here operating at a 180° phase shift, and a first coupler 26. The components 21, 24, 25, 26 are connected in a closed loop in an electrical series connection. In the loop, a generated fixed frequency microwave radiation circulates. The loop has a gain > 1, corresponding to the tapping of energy by the first coupler 26.

At the first coupler 26, a part of the mixed frequency microwave radiation is coupled out, and a fixed frequency microwave signal is accordingly available at an output 26a of the first coupler 26. The fixed frequency microwave signal obtained at output 26a has a phase noise of -135 dBc or lower, preferably -140 dBc or lower, at an offset of 100 kHz. In the described example, the fixed frequency microwave radiation and the fixed frequency microwave signal have a frequency of 10.06 GHz, and is of sinusoidal type.

The tunable microwave source 7 further comprises a tunable frequency generator 27. The tunable frequency generator 27 here includes a second coupler 28, for tapping a part of the fixed frequency microwave signal from output 26a, and feeding said part into a frequency divider 29. The frequency divider 29 generates a frequency divided signal, here with ¼ of the frequency of the fixed frequency microwave signal. The frequency divided signal is fed into a direct digital synthesizer (=DDS) 30 as a reference signal (also called "reference clock", not to be mixed up with the clock phase signal, see below). The DDS 30 generates a tunable HF signal at an output 30a. The tunable HF signal obtained at output 30a has a phase noise of -135 dBc or lower, preferably -140 dBc or lower, at an offset of 100 kHz. In the described example, the tunable HF signal has a frequency that can be varied by the DDS 30 between 0 and 1 GHz, and is of sinusoidal type.

For determining the frequency of the tunable HF signal, the DDS 30 uses coarse default programming (which takes into account the known characteristics of the sample resonator) as well as the AFC adjustment signal from the AFC system (see Fig. 1 and below). The AFC adjustment signal is provided at the AFC system output 12a (see also Fig. 1 and Fig. 3) and fed into an AFC adjustment signal input 31 of the DDS 30. In the illustrated variant, for the AFC system used, the DDS 30 also effects a slight frequency modulation of the tunable HF signal, here according to a clock phase signal with a modulation frequency of 78.125 kHz. The resulting modulation of the tunable microwave signal and its effect on the detected microwave signal at the microwave detector is analyzed for generating the AFC adjustment signal (see below at Fig. 3 and Figs. 4-6 below).

The remaining part of the fixed frequency microwave signal obtained at output 28a of the second coupler 28 (also called "carrier") as well as the tunable HF signal obtained at output 30a of the DDS 30 are fed into a mixer 32. The mixer 32 mixes the fixed frequency microwave signal (or here its remaining part) and the tunable HF signal by a multiplication operation, resulting in a tunable microwave signal at output 32a of the mixer 32. In the illustrated variant, the mixer 32 is a single sideband mixer (not shown in detail). Further, here only the resulting lower frequency mode (of the difference of frequencies) is further used, and the upper frequency mode (of the sum of frequencies) is filtered out (not shown in detail).

The tunable microwave signal obtained at the mixer output 32a then undergoes an amplification at a low noise main amplifier 33. The tunable microwave signal obtained after this amplification at output 7a of the tunable microwave source 7 has a phase noise of -135 dBc or lower, preferably -140 dBc or lower, at an offset of 100 kHz.

**Fig. 3** illustrates the major components of the AFC system 12 of Fig. 1. It should be noted here that the illustrated variant is exemplary for the invention, and other types of AFC systems may be applied in accordance with the invention.

The AFC system 12 is connected to the microwave detector 9 at the AFC processing output 11a of the microwave detector 9, where the measured microwave signal (or a part of it) is present.

This signal is split up, and fed in parallel into a first amplifier 34 and a second amplifier 35. The first amplifier 34 keeps the polarity of the signal, whereas the second amplifier 35 inverts the polarity of the signal. Apart from polarity, amplification factors of amplifiers 34, 35 are identical (in absolute value). Typical amplification factors (in absolute value) are 10 or larger, but may be smaller if desired. For the function of the AFC, the polarity allocation is decisive here, not the amplification factors, so the AFC system 12 may even work without amplification here, but only a polarity inversion in for one of the split signal paths.

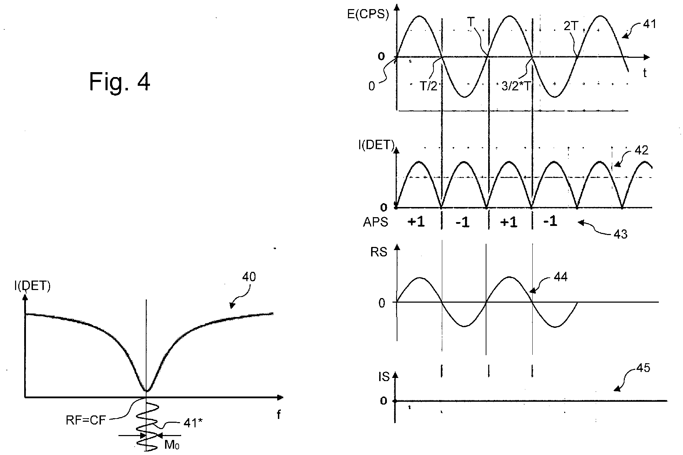

The signals by the amplifiers 34, 35 are then fed into a rectifier unit 36, which has a switching function. The rectifier unit 36 further receives a clock phase signal at a clock phase signal input 37. The clock phase signal indicates the modulation that the tunable HF signal underwent in the DDS (see Fig. 2 above and Fig. 4-6 below), and is of sinusoidal type. During the first half of each sine wave (phase 0 to pi) of the clock phase signal, the first amplifier 34 (but not the second amplifier 35) is connected to the output 36a of the rectifier unit 36.

During the second half of each sine wave (phase pi to 2pi) of the clock phase signal, the second amplifier 35 (but not the first amplifier 34) is connected to the output 36a of the rectifier unit 36.

The resulting rectified signal at output 36a is fed into an integrator unit 38, resulting in an integrated signal at the output 12a of the AFC system 12. This integrated signal is used as the AFD adjustment signal. The AFC system output 12a is connected to the AFC adjustment signal input 31 of the DDS (see also Fig. 2).

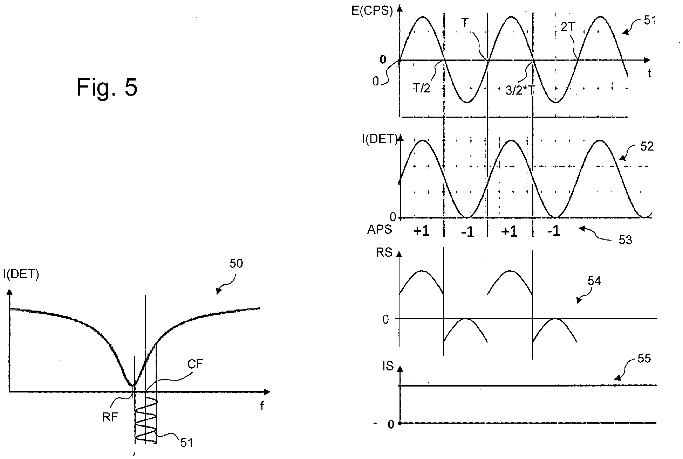

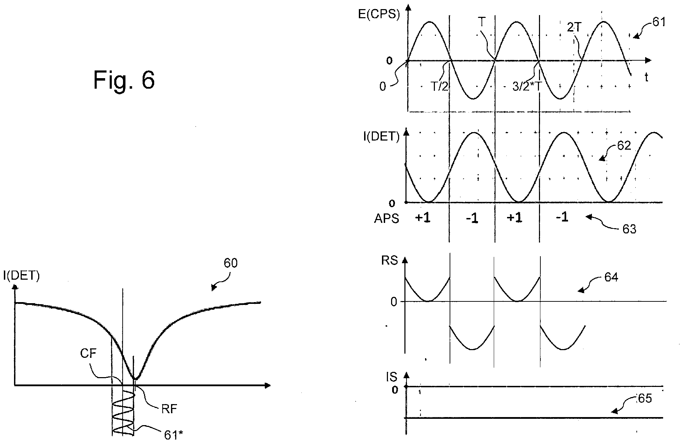

Figs. 4 through 6 illustrate schematically the generation of the AFC adjustment signal in an exemplary variant, in accordance with the setup of Fig. 3. Note that diagram axes in Figs. 5, 6 correspond to diagram axes in Fig. 4, so they are explained only once at Fig. 4. Further note that resonances of the measurement sample are not discussed here, since they are not relevant for the automated frequency control (AFC). Further note that the AFC typically is performed concurrently with EPR measurements on the measurement sample.

Referring to **Fig. 4,** diagram 40 illustrates an intensity I(DET) of a measured microwave signal at the microwave detector (upward axis) as a function of the frequency f (rightward axis) of the tunable microwave signal applied to the sample resonator; diagram 40 is also called an absorption curve of the sample resonator.

The sample resonator has a resonator frequency RF. Note that the resonator frequency RF depends above all from the sample resonator or the geometry of its resonator cavity here, but the resonator frequency RF may vary somewhat due to the type and content of a measurement sample arranged in the sample resonator, and due to other variable circumstances such as temperature. Therefore, the resonance frequency of the sample resonator is always a current resonance frequency. Since EPR measurements should be done with a microwave radiation having a frequency that equals exactly the current resonance frequency of the sample resonator, the microwave source used in EPR measurements should be tunable, and should be adjusted to the current resonance frequency.

When the current frequency of the tunable microwave signal equals to the resonator frequency RF, then the sample resonator absorbs practically all microwave energy, and the measured microwave signal at the microwave detector is at a minimum (and in practice practically zero). However, if the current frequency of the tunable microwave signal is above RF or below RF, then the intensity of the measured microwave signal becomes larger in both cases.

In order to get to know whether the current frequency of the tunable microwave signal is above or below the resonance frequency RF, the frequency of the tunable HF signal, and in this way also the frequency of the tunable microwave signal, is slightly modulated in the vicinity of a center frequency CF according to a clock phase signal (=CPS) here. The center frequency CF of the tunable microwave signal at the same time represents the current frequency of the tunable microwave frequency.

Said clock phase signal is illustrated in diagram 41. It shows the time t on the right hand axis, and the elongation E(CPS) of the clock phase signal on the upward axis. The clock phase signal is of sinusoidal type, and here has a frequency of 78.125 kHz, which is called modulation frequency MF here. Applying this modulation, the field strength of the tunable microwave signal TMS then can be described as

$$TMS = A_0 * \sin \{ 2\pi * [CF + M_0 * \sin(2\pi * MF * t)] * t \}$$

with Ac: amplitude of the tunable microwave signal, CF: center frequency of the tunable microwave signal, $M_0$ modulation amplitude of the clock phase signal, and MF: modulation frequency of the clock phase signal, and t time. In other words, the frequency of the tunable microwave signal oscillates with time in a range of +/- $M_0$ about the center frequency CF, and said oscillation has a frequency MF. It should be noted here that CF is typically on the order of about 10 GHz or 35 GHz, and corresponds to the microwave frequency at which the EPR measurement takes place, whereas MF is much smaller at about 78 kHz here. Note that diagram 40 gives an indication of a typical modulation amplitude $M_0$ as compared to the width of the resonance curve, see small CPS curve 41*, which illustrates the time in upward direction, and frequency elongation to the right/left direction.

Diagram 42 illustrates the detected intensity I(DET) of the measured microwave signal at the microwave detector over the course of a few periods T of oscillation of the clock phase signal (note that T equals to one period of oscillation of the clock phase signal with T=1/MF, and corresponds to a phase of $2\pi$), for the situation of Fig. 4 when the center frequency CF is equal to the resonance frequency RF, see also diagram 40. When the clock phase signal is at 0, T/2 (resp. $\pi$), T (resp. $2\pi$), 3/2*T (resp. $3\pi$), 2T (resp. $4\pi$) and so on, its elongation is zero, and the current frequency of the tunable microwave signal is exactly RF. Then the intensity I(DET) in diagram 42 is at its minimum at about 0 at these points of time. In between these points of time, the intensity increases to a maximum and decreases again in each case; it does not matter whether the frequency of the tunable microwave signal is above RF or below RF between each two chosen points of time, since the situation is symmetric if CF=RF.

The detected microwave signal then undergoes a rectifying amplification (see Fig. 3, Ref. 34, 35, 36), wherein in the respective first half wave of each sinusoidal oscillation of the clock phase signal the polarity is kept, and in each second half wave the polarity is inverted, see amplification polarity scheme APS 43. The resulting rectified signal RS is illustrated in diagram 44, with time t shown on the rightward axis, and the rectified signal RS shown on the upward axis. The rectified signal RS swings "symmetrically" about the axis of zero signal strength, with about equal areas below the signal curve on the positive side and on the negative side.

When integrating the rectified signal, the resulting integrated signal IS of diagram 45 is constantly zero. The integrated signal IS corresponds to the AFC adjustment signal. The zero value indicates that the current center frequency CF is equal to the resonance frequency RF, and no correction of the center frequency is necessary.

Fig. 5, in contrast, illustrates the situation if the center frequency CF is larger than the resonance frequency RF, compare diagram 50. The same clock phase signal as before is applied, compare diagram 51, and also the small CPS curve 51* in diagram 50.

At the points of time of the zero crossings of the elongation of the clock phase signal, i.e. at 0, T/2, T, 3/2*T, 2T, etc., the intensity I(DET) of the measured microwave signal illustrated in diagram 52 is non-zero and positive, and increases from t=0 to a maximum at about T/4, and then decreases again until T/2. Then the intensity further decreases, and reaches a minimum here about zero at ¾*T, but then increases again until T.

The same amplification polarity scheme APS 53 is then applied as before. The rectified signal RS, compare diagram 54, is generally large and positive from 0 to T/2, and generally smaller (in absolute value) and negative between T/2 and T. In particular, the area under the RS curve from 0 to T/2 is larger (in absolute value) than from T/2 to T. The resulting integrated signal IS, shown in diagram 55, is then positive. This positive value of the integrated signal IS, or AFC adjustment signal, indicates that the center frequency CF of the tunable microwave signal should be lowered, in order to approach the resonance frequency RF.

Fig. 6 now illustrates the situation if the center frequency CF is smaller than the resonance frequency RF, compare diagram 60. The same clock phase signal as before is applied, compare diagram 61, and also the small CPS curve 61* in diagram 60.

At the points of time of the zero crossings of the elongation of the clock phase signal, i.e. at 0, T/2, T, 3/2*T, 2T, etc., the intensity I(DET) of the measured microwave signal as illustrated in diagram 62 is non-zero and positive, and decreases from t=0 to a minimum of about zero here at about T/4, and then increases again until T/2. Then the intensity further increases, and reaches here a maximum at ¾*T, but then decreases again until T.

The same amplification polarity scheme APS 63 is then applied as before. The rectified signal RS, compare diagram 64, is generally small and positive from 0 to T/2, and generally larger (in absolute value) and negative between T/2 and T. In particular, the area RS curve from 0 to T/2 is smaller (in absolute value) than from T/2 to T. The resulting integrated signal IS, shown in diagram 65, is then negative. This negative value of the integrated signal IS, or AFC adjustment signal, indicates that the center frequency CF of the tunable microwave signal should be increased, in order to approach the resonance frequency RF.

The DDS analyses the AFC adjustment signal. If the AFC adjustment signal is positive, then the frequency of the tunable HF signal is lowered a bit. If the AFC adjustment signal is negative, then the frequency of the tunable HF signal is increased a bit. As long as resp. as soon as the AFC adjustment signal is zero, the current frequency of the tunable HF signal is kept constant. In this way, a closed loop control of the current frequency of the tunable microwave signal can be established, keeping it very accurately at the current resonance frequency of the sample resonator.

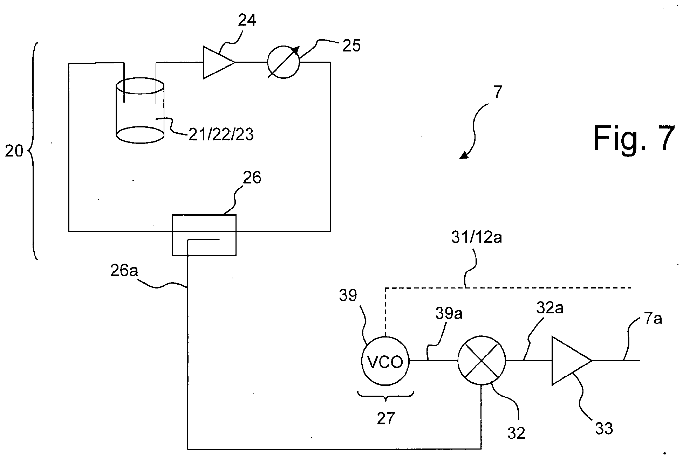

**Fig. 7** illustrates an alternative design of a tunable microwave source 7 in accordance with the invention, which may be used in the EPR spectrometer illustrated in Fig. 1. The tunable microwave source 7 of Fig. 7 is similar to the tunable microwave source shown in Fig. 2, so only the major differences are explained below.

The tunable microwave source 7 comprises a fixed frequency microwave oscillator 20 as already described, and at the first coupler 26, a part of the mixed frequency microwave radiation is coupled out, so a fixed frequency microwave signal is accordingly available at an output 26a of the first coupler 26, as before.

The tunable microwave source 7 further comprises a tunable frequency generator 27, which here includes a voltage controlled oscillator (=VCO) 39.

The VCO 39 generates a tunable HF signal at a VCO output 39a. The tunable HF signal is here of sinusoidal type. The frequency of the tunable HF signal generated depends on a control voltage present at the VCO 39. Said control voltage is here obtained by adding a base signal (which results from a coarse default programming, taking into account the known characteristics of the sample resonator, not further illustrated), the AFC adjustment signal from the AFC system or a signal derived from said AFC adjustment signal (see above), and a clock phase signal or a signal derived from said clock phase signal (see above). The AFC adjustment signal is provided at the AFC system output 12a (see also Fig. 1 and Fig. 3) and fed into the AFC adjustment signal input 31 of the VCO 39. For the AFC system used here, the VCO 39 also effects a slight frequency modulation of the tunable HF signal according to said clock phase signal, here again with a modulation frequency of 78.125 kHz (not further illustrated).

The tunable HF signal obtained at VCO output 39a has a phase noise of -135 dBc or lower, preferably -140 dBc or lower, at an offset of 100 kHz. In the described example, the tunable HF signal has a frequency that can be varied by the VCO 39 between 0 and 1 GHz.

The fixed frequency microwave signal obtained at output 26a as well as the tunable HF signal obtained at the VCO output 39a are fed into the mixer 32. The tunable microwave signal obtained at the mixer output 32a then undergoes an amplification at the low noise main amplifier 33, as before.

List of reference signs

| | |
|---|---|
| 1 | EPR spectrometer |
| 2 | sample resonator |
| 3 | sample area |
| 4 | measurement sample |
| 5 | magnet system |
| 6 | electronic control unit |
| 7 | tunable microwave source |
| 7a | output (tunable microwave source) |
| 8 | circulator |
| 9 | microwave detector |
| 10 | reference arm unit |
| 11a | AFC processing output (of microwave detector) |
| 11b | sample detector output (of microwave detector) |
| 12 | AFC system |
| 12a | AFC system output |
| 20 | fixed frequency microwave oscillator |
| 21 | selective return chain element |
| 22 | resonant cavity |
| 23 | resonant cylindrical cavity |
| 24 | low noise amplifier |
| 25 | phase shifter |
| 26 | (first) coupler (of fixed frequency microwave oscillator) |
| 26a | output (first coupler) |
| 27 | tunable frequency generator |

| | |
|---|---|
| 28 | (second) coupler (of tunable frequency generator) |
| 28a | output (second coupler) |
| 29 | frequency divider |
| 30 | direct digital synthesizer (=DDS) |
| 30a | DDS output |
| 31 | AFC adjustment signal input |
| 32 | mixer |
| 32a | output (mixer) |
| 33 | low noise main amplifier |
| 34 | first amplifier (keeps polarity) |
| 35 | second amplifier (changes polarity) |
| 36 | rectifying unit |
| 36a | output (rectifying unit) |
| 37 | clock phase signal input |
| 38 | integrating unit |
| 39 | voltage controlled oscillator (=VCO) |
| 39a | VCO output |
| 40 | diagram/intensity of measured microwave frequency as function of frequency of tunable microwave signal (with CF=RF) |
| 41 | diagram/elongation of clock phase signal as function of time |
| 41* | small CPS curve |
| 42 | diagram/intensity of measured microwave signal as function of time |
| 43 | amplification polarity list |
| 44 | diagram/elongation of rectified signal as a function of time |
| 45 | diagram/integrated signal as function of time |
| 50 | diagram/intensity of measured microwave frequency as function of frequency of tunable microwave signal (with CF>RF) |
| 51 | diagram/elongation of clock phase signal as function of time |
| 51* | small CPS curve |
| 52 | diagram/intensity of measured microwave signal as function of time |
| 53 | amplification polarity scheme |
| 54 | diagram/elongation of rectified signal as a function of time |
| 55 | diagram/integrated signal as function of time |
| 60 | diagram/intensity of measured microwave frequency as function of frequency of tunable microwave signal (with CF<RF) |
| 61 | diagram/elongation of clock phase signal as function of time |
| 61* | small CPS curve |
| 62 | diagram/intensity of measured microwave signal as function of time |
| 63 | amplification polarity scheme |
| 64 | diagram/elongation of rectified signal as a function of time |
| 65 | diagram/integrated signal as function of time |
| | |
| APS | amplification detection scheme |
| CF | center frequency/current frequency of the tunable microwave signal |
| CPS | clock phase signal |
| DET | measured/detected microwave signal |
| E(...) | elongation of ... |
| I(...) | intensity of ... |
| IS | integrated signal |
| f | frequency |
| RF | resonance frequency (sample resonator) |
| RS | rectified signal |
| t | time |
| T | oscillation period (clock phase signal) |

**Claims**

1. An electron paramagnetic resonance (=EPR) spectrometer (1), comprising

- a sample resonator (2), comprising a sample area (3) for a measurement sample (4) to be held in the sample resonator (2);
- a tunable microwave source (7), for generating a tunable microwave signal to be applied to the sample resonator (2),
- a magnet system (5), for generating a variable magnetic field to be applied at least to the sample area (3) in the sample resonator (2), and
- and a microwave detector (9) connected to the sample resonator (2) for detecting microwave radiation,
**characterized in
that** the tunable microwave source (7) comprises
- a fixed frequency microwave oscillator (20), for generating a fixed frequency microwave signal,
- a tunable frequency generator (27), for generating a tunable high frequency (=HF) signal, wherein the tunable HF signal is of lower frequency as compared to the fixed frequency microwave signal, and
- a mixer (32), for mixing the fixed frequency microwave signal and the tunable HF signal, thus generating a tunable microwave signal.

2. An EPR spectrometer (1) according to claim 1, **characterized in**

   **that** the fixed frequency microwave oscillator (20) is suitable for providing the fixed frequency microwave signal with a phase noise of -135dBc or less at an offset of 100 kHz,
   and **that** the tunable frequency generator (27) is suitable for providing the tunable HF signal with a phase noise of -135 dBc or less at an offset of 100 kHz.

3. An EPR spectrometer (1) according to one of the preceding claims,
   **characterized in that** the EPR spectrometer (1) further comprises an automatic frequency control (=AFC) system (12), wherein the AFC system (12) is adapted to

   - receive a measured microwave signal provided by the microwave detector (9);
   - derive an AFC adjustment signal from the measured microwave signal, with the AFC adjustment signal indicating a deviation of a current frequency (CF) of the measured microwave signal from a current resonance frequency (RF) of the sample resonator (2); and
   - feed the AFC adjustment signal into the tunable frequency generator (27), for continuously controlling a current frequency of the tunable HF signal, such that the current frequency (CF) of the tunable microwave signal is continuously adjusted to the current resonance frequency (RF) of the sample resonator (2).

4. An EPR spectrometer (1) according to one of the preceding claims, **characterized in that** the fixed frequency microwave oscillator (20) includes a resonant cavity (22), in particular a resonant cylindrical cavity (23).

5. An EPR spectrometer (1) according to one of the preceding claims, **characterized in that** the fixed frequency microwave oscillator (20) includes a selective return chain element (21), a low noise amplifier (24), a phase shifter (25) and a coupler (26) connected circularly in series.

6. An EPR spectrometer (1) according to one of the claims 1 through 5, **characterized in that** the tunable frequency generator (27) includes a direct digital synthesizer (=DDS) (30).

7. An EPR spectrometer (1) according to claim 6, **characterized in that** the tunable frequency generator (27) further includes

   - a coupler (28) for obtaining a part of the fixed frequency microwave signal, and
   - a frequency divider (29), for generating a frequency-divided signal from said part of the fixed frequency microwave signal, and providing the frequency divided signal as a reference signal into the DDS (30).

8. An EPR spectrometer (1) according to one of the claims 1 through 5, **characterized in that** the tunable frequency generator (27) includes a voltage controlled oscillator (=VCO) (39).

9. An EPR spectrometer (1) according to one of the preceding claims, **characterized in that** mixer (32) only preserves a difference of the fixed frequency microwave signal and the tunable HF signal.

10. An EPR spectrometer (1) according to one of the preceding claims, **characterized in that** the EPR spectrometer (1) further includes a low noise main amplifier (33), for amplifying the tunable microwave signal provided by the mixer (32) before applying it to the sample resonator (2).

11. An EPR spectrometer (1) according to one of the preceding claims, **characterized in that**

a) the fixed frequency microwave oscillator (20) is adapted to generate a fixed frequency microwave signal of a frequency Ffix with

8.5 GHz ≤ Ffix ≤ 10.5 GHz,
and the tunable frequency generator (27) is adapted to generate a tunable HF signal of up to a frequency Fmax with
0.5 GHz ≤ Fmax ≤ 1.5 GHz,
in particular wherein Ffix=10 GHz and Fmax=1 GHz,

or that
b) the fixed frequency microwave oscillator (20) is adapted to generate a fixed frequency microwave signal of a frequency Ffix with

32.0 GHz ≤ Ffix ≤ 36.0 GHz,
and the tunable frequency generator (27) is adapted to generate a tunable HF signal of up to a frequency Fmax with
1.0 GHz ≤ Fmax ≤ 3.0 GHz,
in particular wherein Ffix=35 GHz and Fmax=2 GHz.

12. A method for measuring an EPR spectrum of a measurement sample (4), wherein the measurement sample (4) is positioned in a sample area (3) of a sample resonator (2),

wherein a tunable microwave signal is applied to the sample resonator (2), wherein a variable magnetic field is applied at least to the measurement sample (4) in the sample area (3) in the sample resonator (2), and wherein a microwave detector (9) connected to the sample resonator (2) detects microwave radiation, **characterized in**
**that** the tunable microwave signal is generated by mixing a fixed frequency microwave signal obtained from a fixed frequency microwave oscillator (20) with a tunable high frequency (=HF) signal obtained from tunable frequency generator (27),
wherein the tunable HF signal has a lower frequency as compared to the fixed frequency microwave signal, in particular wherein the method is performed with an EPR spectrometer (1) according to one of the preceding claims.

13. A method according to claim 12, **characterized in that** the fixed frequency microwave signal has a phase noise of -135 dBc or less at an offset of 100 kHz, and that the tunable HF signal has a phase noise of -135 dBc or less at an offset of 100 kHz.

14. A method according to claim 12 or 13, **characterized in that** the method applies an automatic frequency control (=AFC) including

- receiving a measured microwave signal provided by the microwave detector (9);
- deriving an AFC adjustment signal from the measured microwave signal, with the AFC adjustment signal indicating a deviation of a current frequency (CF) of the measured microwave signal from a current resonance frequency (RF) of the sample resonator (2);
- feeding the AFC adjustment signal into the tunable frequency generator (27), thus continuously controlling a current frequency of the tunable HF signal, such that the current frequency (CF) of the tunable microwave signal is continuously adjusted to the current resonance frequency (RF) of the sample resonator (2).

15. A method according to claim 14, **characterized in that** the automatic frequency control (=AFC) further includes

- effecting a modulation of the tunable HF signal with a modulation frequency (MF), resulting in a modulation of the tunable microwave signal with the modulation frequency (MF),
- deriving the AFC adjustment signal from the measured microwave signal using said modulation.

**Amended claims in accordance with Rule 137(2) EPC.**

1. An electron paramagnetic resonance (=EPR) spectrometer (1), comprising

   - a sample resonator (2), comprising a sample area (3) for a measurement sample (4) to be held in the sample resonator (2);
   - a tunable microwave source (7), for generating a tunable microwave signal to be applied to the sample resonator (2),
   - a magnet system (5), for generating a variable magnetic field to be applied at least to the sample area (3) in the sample resonator (2), and
   - and a microwave detector (9) connected to the sample resonator (2) for detecting microwave radiation, wherein the tunable microwave source (7) comprises
   - a fixed frequency microwave oscillator (20), for generating a fixed frequency microwave signal,
   - a tunable frequency generator (27), for generating a tunable high frequency (=HF) signal, wherein the tunable HF signal is of lower frequency as compared to the fixed frequency microwave signal, and
   - a mixer (32), for mixing the fixed frequency microwave signal and the tunable HF signal, thus generating a tunable microwave signal,

     wherein the tunable frequency generator (27) includes a direct digital synthesizer (=DDS) (30),
     **characterized in**
     **that** the tunable frequency generator (27) further includes

   - a coupler (28) for obtaining a part of the fixed frequency microwave signal, and
   - a frequency divider (29), for generating a frequency-divided signal from said part of the fixed frequency microwave signal, and providing the frequency divided signal as a reference signal into the DDS (30).

2. An electron paramagnetic resonance (=EPR) spectrometer (1), comprising

   - a sample resonator (2), comprising a sample area (3) for a measurement sample (4) to be held in the sample resonator (2);
   - a tunable microwave source (7), for generating a tunable microwave signal to be applied to the sample resonator (2),
   - a magnet system (5), for generating a variable magnetic field to be applied at least to the sample area (3) in the sample resonator (2), and
   - and a microwave detector (9) connected to the sample resonator (2) for detecting microwave radiation, wherein the tunable microwave source (7) comprises
   - a fixed frequency microwave oscillator (20), for generating a fixed frequency microwave signal,
   - a tunable frequency generator (27), for generating a tunable high frequency (=HF) signal, wherein the tunable HF signal is of lower frequency as compared to the fixed frequency microwave signal, and
   - a mixer (32), for mixing the fixed frequency microwave signal and the tunable HF signal, thus generating a tunable microwave signal,

   **characterized in**
   **that** the tunable frequency generator (27) includes a voltage controlled oscillator (=VCO) (39) configured such that the tunable HF signal obtained at an output (39a) of the VCO (39) is fed into the mixer (32).

3. An EPR spectrometer (1) according to one of the preceding claims, **characterized in that** the EPR spectrometer (1) further comprises an automatic frequency control (=AFC) system (12), wherein the AFC system (12) is adapted to

   - receive a measured microwave signal provided by the microwave detector (9);
   - derive an AFC adjustment signal from the measured microwave signal, with the AFC adjustment signal indicating a deviation of a current frequency (CF) of the measured microwave signal from a current resonance frequency (RF) of the sample resonator (2); and
   - feed the AFC adjustment signal into the tunable frequency generator (27), for continuously controlling a current frequency of the tunable HF signal, such that the current frequency (CF) of the tunable microwave signal is continuously adjusted to the current resonance frequency (RF) of the sample resonator (2).

4. An EPR spectrometer (1) according to one of the preceding claims, **characterized in that** the fixed frequency microwave oscillator (20) includes a resonant cavity (22), in particular a resonant cylindrical cavity (23).

5. An EPR spectrometer (1) according to one of the preceding claims, **characterized in that** the fixed frequency microwave oscillator (20) includes a selective return chain element (21), a low noise amplifier (24), a phase shifter (25) and a coupler (26) connected circularly in series.

6. An EPR spectrometer (1) according to one of the preceding claims, **characterized in that** the mixer (32) only preserves a lower frequency mode of the difference of frequencies of the fixed frequency microwave signal and the tunable HF signal.

7. An EPR spectrometer (1) according to one of the preceding claims, **characterized in that** the EPR spectrometer (1) further includes a low noise main amplifier (33), for amplifying the tunable microwave signal provided by the mixer (32) before applying it to the sample resonator (2).

8. An EPR spectrometer (1) according to one of the preceding claims, **characterized in that**

> a) the fixed frequency microwave oscillator (20) is adapted to generate a fixed frequency microwave signal of a frequency Ffix with
> $8.5\,\text{GHz} \leq \text{Ffix} \leq 10.5\,\text{GHz}$, and the tunable frequency generator (27) is adapted to generate a tunable HF signal of up to a frequency Fmax with $0.5\,\text{GHz} \leq \text{Fmax} \leq 1.5\,\text{GHz}$, in particular wherein Ffix=10 GHz and Fmax=1 GHz, or that
> b) the fixed frequency microwave oscillator (20) is adapted to generate a fixed frequency microwave signal of a frequency Ffix with $32.0\,\text{GHz} \leq \text{Ffix} \leq 36.0\,\text{GHz}$, and the tunable frequency generator (27) is adapted to generate a tunable HF signal of up to a frequency Fmax with
> $1.0\,\text{GHz} \leq \text{Fmax} \leq 3.0\,\text{GHz}$, in particular wherein Ffix=35 GHz and Fmax=2 GHz.

9. Use of an EPR spectrometer (1) according to one of the preceding claims for measuring an EPR spectrum of a measurement sample (4),

> wherein the measurement sample (4) is positioned in the sample area (3) of the sample resonator (2),
> wherein a tunable microwave signal is applied to the sample resonator (2), wherein a variable magnetic field is applied at least to the measurement sample (4) in the sample area (3) in the sample resonator (2),
> wherein the microwave detector (9) connected to the sample resonator (2) detects microwave radiation,
> wherein the tunable microwave signal is generated by mixing the fixed frequency microwave signal obtained from the fixed frequency microwave oscillator (20) with the tunable high frequency (=HF) signal obtained from tunable frequency generator (27),
> and wherein the tunable HF signal has a lower frequency as compared to the fixed frequency microwave signal.

10. Use according to claim 9, **characterized in that** an automatic frequency control (=AFC) is applied including

> - receiving a measured microwave signal provided by the microwave detector (9);
> - deriving an AFC adjustment signal from the measured microwave signal, with the AFC adjustment signal indicating a deviation of a current frequency (CF) of the measured microwave signal from a current resonance frequency (RF) of the sample resonator (2);
> - feeding the AFC adjustment signal into the tunable frequency generator (27), thus continuously controlling a current frequency of the tunable HF signal, such that the current frequency (CF) of the tunable microwave signal is continuously adjusted to the current resonance frequency (RF) of the sample resonator (2).

11. Use according to claim 10, **characterized in that** the automatic frequency control (=AFC) further includes

> - effecting a modulation of the tunable HF signal with a modulation frequency (MF), resulting in a modulation of the tunable microwave signal with the modulation frequency (MF),
> - deriving the AFC adjustment signal from the measured microwave signal using said modulation.

Fig. 1

Fig. 2

Fig. 3

# Fig. 4

# Fig. 5

I(DET)

50

CF

RF

51

E(CPS)

T

2T

51

0

0

T/2

3/2*T

t

I(DET)

52

0

APS  +1  -1  +1  -1

53

RS

54

0

IS

55

- 0

# Fig. 6

Fig. 7

Europäisches
Patentamt

European
Patent Office

Office européen
des brevets

## EUROPEAN SEARCH REPORT

**Application Number**

EP 24 31 5160

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HE? YU? ET AL: "A low-noise X-band microwave source with digital automatic frequency control for electron paramagnetic resonance spectroscopy", CHINESE PHYSICS B, CHINESE PHYSICS B, BRISTOL GB, vol. 32, no. 8, 24 April 2023 (2023-04-24) , XP020474670, ISSN: 1674-1056, DOI: 10.1088/1674-1056/ACCF7E [retrieved on 2023-04-24] | 1-6,8-15 | INV. G01R33/60 |
| A | * the whole document * | 7 | |
| A | US 4 803 624 A (PILBROW JOHN R [AU] ET AL) 7 February 1989 (1989-02-07) * column 2, lines 54-60 * | 1-15 | |
| A | ROKEAKH A I ET AL: "Continuous wave desktop coherent superheterodyne X-band EPR spectrometer", JOURNAL OF MAGNETIC RESONANCE, ACADEMIC PRESS, ORLANDO, FL, US, vol. 338, 26 March 2022 (2022-03-26), XP087031488, ISSN: 1090-7807, DOI: 10.1016/J.JMR.2022.107206 [retrieved on 2022-03-26] * figures 1-3 * | 1-15 | TECHNICAL FIELDS SEARCHED (IPC) G01R |

-/--

The present search report has been drawn up for all claims

| Place of search | Date of completion of the search | Examiner |
|---|---|---|
| Munich | 1 October 2024 | Ó Donnabháin, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................
& : member of the same patent family, corresponding document

EPO FORM 1503 03.82 (P04C01)

Europäisches
Patentamt

European
Patent Office

Office européen
des brevets

**EUROPEAN SEARCH REPORT**

**Application Number**

EP 24 31 5160

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KOZIOL J ET AL: "Continuous wave electron paramagnetic resonance L-band spectrometer with direct digitalization using time-locked subsampling", JOURNAL OF MAGNETIC RESONANCE, ACADEMIC PRESS, ORLANDO, FL, US, vol. 322, 7 November 2020 (2020-11-07), XP086441438, ISSN: 1090-7807, DOI: 10.1016/J.JMR.2020.106870 [retrieved on 2020-11-07] * figure 5 * ----- | 1-15 | |
| | | | TECHNICAL FIELDS SEARCHED (IPC) |

The present search report has been drawn up for all claims

| Place of search | Date of completion of the search | Examiner |
|---|---|---|
| Munich | 1 October 2024 | Ó Donnabháin, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 31 5160

This annex lists the patent family members relating to the patent documents cited in the above-mentioned European search report.
The members are as contained in the European Patent Office EDP file on
The European Patent Office is in no way liable for these particulars which are merely given for the purpose of information.

01-10-2024

| Patent document cited in search report | Publication date | Patent family member(s) | Publication date |
|---|---|---|---|
| US 4803624 A | 07-02-1989 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5309118 A

- CN 209881736

**Non-patent literature cited in the description**

- **WEI et al.** *Photonics Research*, January 2018, vol. 6 (1), 12-17